# EUROPEAN PATENT SPECIFICATION

(11) **EP 3 231 017 B1**
(45) Date of publication and mention of the grant of the patent: **19.06.2019**
(21) Application number: 15867338.4
(22) Date of filing: 07.12.2015
(51) Int. Cl.: H01L 31/0224, H01L 31/068

(54) **LASER STOP LAYER FOR FOIL-BASED METALLIZATION OF SOLAR CELLS**
LASERSTOPPSCHICHT FÜR FOLIENBASIERTE METALLISIERUNG VON SOLARZELLEN
COUCHE D'ARRÊT DE LASER POUR MÉTALLISATION À BASE DE FEUILLE DE CELLULES SOLAIRES

(30) Priority: 08.12.2014 US 201414563723
(43) Date of publication of application: 18.10.2017
(73) Proprietor: SunPower Corporation, San Jose, CA 95134 (US)
(72) Inventor: HSIA, Benjamin Ian, Fremont, California 94538 (US); HARLEY, Gabriel, Mountain View, California 94043 (US); KIM, Taeseok, Pleasanton, California 94588 (US); SEWELL, Richard Hamilton, Los Altos, California 94024 (US); KIM, Sung Dug, Pleasanton, California 94588 (US)
(74) Representative: Grünecker Patent- und Rechtsanwälte PartG mbB
(86) International application number: PCT/US2015/064341
(87) International publication number: WO 2016/094328

(56) References cited:
- EP-A1- 2 717 331
- WO-A2-2013/182955
- US-A1- 2010 051 085
- US-A1- 2013 133 729
- US-A1- 2013 160 812
- US-A1- 2013 194 723
- US-A1- 2013 244 371
- US-A1- 2014 179 056

## Description

### TECHNICAL FIELD

Embodiments of the present disclosure are in the field of renewable energy and, in particular, include approaches for foil-based metallization of solar cells and the resulting solar cells.

### BACKGROUND

Photovoltaic cells, commonly known as solar cells, are well known devices for direct conversion of solar radiation into electrical energy. Generally, solar cells are fabricated on a semiconductor wafer or substrate using semiconductor processing techniques to form a p-n junction near a surface of the substrate. Solar radiation impinging on the surface of, and entering into, the substrate creates electron and hole pairs in the bulk of the substrate. The electron and hole pairs migrate to p-doped and n-doped regions in the substrate, thereby generating a voltage differential between the doped regions. The doped regions are connected to conductive regions on the solar cell to direct an electrical current from the cell to an external circuit coupled thereto.

Efficiency is an important characteristic of a solar cell as it is directly related to the capability of the solar cell to generate power. Likewise, efficiency in producing solar cells is directly related to the cost effectiveness of such solar cells. Accordingly, techniques for increasing the efficiency of solar cells, or techniques for increasing the efficiency in the manufacture of solar cells, are generally desirable. Some embodiments of the present disclosure allow for increased solar cell manufacture efficiency by providing novel processes for fabricating solar cell structures. Some embodiments of the present disclosure allow for increased solar cell efficiency by providing novel solar cell structures. The following documents US 2013/133729 A1 and EP 2717 331 A1 describe solar cells as known in the prior art.

### BRIEF DESCRIPTION OF THE DRAWINGS

Figures 1A-1F illustrate cross-sectional views of various stages in the fabrication of a solar cell using foil-based metallization, in accordance with an embodiment of the present disclosure, wherein:
   Figure 1A illustrates a stage in solar cell fabrication following formation of alternating N-type and P-type semiconductor regions (emitter regions) formed above a portion of a back surface of a substrate of a solar cell;
   Figure 1B illustrates the structure of Figure 1A following formation of a paste between adjacent ones of the alternating N-type and P-type semiconductor regions;
   Figure 1C illustrates the structure of Figure 1B following curing of the paste to form non-conductive material regions in alignment with locations between the alternating N-type and P-type semiconductor regions;
   Figure 1D illustrates the structure of Figure 1C following optional formation of a plurality of metal seed material regions to provide a metal seed material region on each of the alternating N-type and P-type semiconductor regions;
   Figure 1E illustrates the structure of Figure 1D following adhering of a metal foil to the alternating N-type and P-type semiconductor regions; and
   Figure 1F illustrates the structure of Figure 1E following laser ablating through the metal foil in alignment with the locations between the alternating N-type and P-type semiconductor regions to isolate regions of remaining metal foil in alignment with the alternating N-type and P-type semiconductor regions.
Figure 2 is a flowchart listing operations in a method of fabricating a solar cell as corresponding to Figures 1A-1F, in accordance with an embodiment of the present disclosure.
Figure 3 illustrates a cross-sectional views of another solar cell having foil-based metallization, in accordance with another embodiment of the present disclosure.

### DETAILED DESCRIPTION

The subject matter of the present invention is defined in claim 1. The following detailed description is merely illustrative in nature and is not intended to limit the embodiments of the subject matter or the application and uses of such embodiments. As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, brief summary or the following detailed description.

Terminology. The following paragraphs provide definitions and/or context for terms found in this disclosure (including the appended claims):
"Comprising." This term is open-ended. As used in the appended claims, this term does not foreclose additional structure or steps.

"First," "Second," etc. As used herein, these terms are used as labels for nouns that they precede, and do not imply any type of ordering (e.g., spatial, temporal, logical, etc.). For example, reference to a "first" solar cell does not necessarily imply that this solar cell is the first solar cell in a sequence; instead the term "first" is used to differentiate this solar cell from another solar cell (e.g., a "second" solar cell).

"Coupled" - The following description refers to elements or nodes or features being "coupled" together. As used herein, unless expressly stated otherwise, "coupled" means that one element/node/feature is directly or indirectly joined to (or directly or indirectly communicates with) another element/node/feature, and not necessarily mechanically.

In addition, certain terminology may also be used in the following description for the purpose of reference only, and thus are not intended to be limiting. For example, terms such as "upper", "lower", "above", and "below" refer to directions in the drawings to which reference is made. Terms such as "front", "back", "rear", "side", "outboard", and "inboard" describe the orientation and/or location of portions of the component within a consistent but arbitrary frame of reference which is made clear by reference to the text and the associated drawings describing the component under discussion. Such terminology may include the words specifically mentioned above, derivatives thereof, and words of similar import.

"Inhibit" - As used herein, inhibit is used to describe a reducing or minimizing effect. When a component or feature is described as inhibiting an action, motion, or condition it may completely prevent the result or outcome or future state completely. Additionally, "inhibit" can also refer to a reduction or lessening of the outcome, performance, and/or effect which might otherwise occur. Accordingly, when a component, element, or feature is referred to as inhibiting a result or state, it need not completely prevent or eliminate the result or state.

Approaches for foil-based metallization of solar cells and the resulting solar cells are described herein. In the following description, numerous specific details are set forth, such as specific paste compositions and process flow operations, in order to provide a thorough understanding of embodiments of the present disclosure. It will be apparent to one skilled in the art that embodiments of the present disclosure may be practiced without these specific details. In other instances, well-known fabrication techniques, such as lithography and patterning techniques, are not described in detail in order to not unnecessarily obscure embodiments of the present disclosure. Furthermore, it is to be understood that the various embodiments shown in the figures are illustrative representations and are not necessarily drawn to scale.

Disclosed herein are methods of fabricating solar cells. In one embodiment, a method of fabricating a solar cell involves forming a plurality of alternating N-type and P-type semiconductor regions in or above a substrate. The method also involves forming a paste between adjacent ones of the alternating N-type and P-type semiconductor regions. The method also involves curing the paste to form non-conductive material regions in alignment with locations between the alternating N-type and P-type semiconductor regions. The method also involves adhering a metal foil to the alternating N-type and P-type semiconductor regions. The method also involves laser ablating through the metal foil in alignment with the locations between the alternating N-type and P-type semiconductor regions to isolate regions of remaining metal foil in alignment with the alternating N-type and P-type semiconductor regions. The non-conductive material regions act as a laser stop during the laser ablating.

Also disclosed herein are solar cells. In one embodiment, a solar cell includes a substrate. A plurality of alternating N-type and P-type semiconductor regions is disposed in or above the substrate. A plurality of non-conductive material regions is in alignment with locations between the alternating N-type and P-type semiconductor regions. The plurality of non-conductive material regions include a binder and an opacifying pigment, where the opacifying pigment amounts to greater than approximately 50% of the total weight composition of the plurality of non-conductive material regions. A plurality of conductive contact structures is electrically connected to the plurality of alternating N-type and P-type semiconductor regions. Each conductive contact structure includes a metal foil portion disposed above and in alignment with a corresponding one of the alternating N-type and P-type semiconductor regions.

Also disclosed herein are pastes and paste formulations for fabricating solar cells. In one embodiment, a paste for forming a non-conductive region of a solar cell includes a binder, an opacifying pigment, and an organic medium mixed with the binder and the opacifying pigment. The opacifying pigment makes up greater than approximately 25% of a total weight composition of the paste, while the organic medium makes up less than approximately 50% of the total weight composition of the paste.

One or more embodiments described herein are directed to metal (such as aluminum) based metallization for solar cells. As a general consideration, back contact solar cells typically require patterned metal of two types of polarity on the backside of the solar cell. Where pre-patterned metal is not available due to cost, complexity, or efficiency reasons, low cost, low materials processing of a blanket metal often favors laser-based pattern approaches. In an embodiment, an aluminum metallization process for interdigitated back contact (IBC) solar cells is disclosed. In an embodiment, a M2-M1 process is referenced, where the M2 layer may be fabricated from a metal foil, while the M1 layer is a metal layer (which may be referred to as a seed layer) formed on a portion of a solar cell.

For high efficiency cells, a metal patterning process on the back of the cell typically must meet two requirements: (1) complete isolation of the metal, and (2) damage free-processing. For mass-manufacturing, the process may need to also be a high-throughput process, such as greater than 500 wafers an hour throughput. For complex patterns, using a laser to pattern thick (e.g., greater than 1micron) or highly reflective metal (e.g., aluminum) on top of silicon can poses a substantial throughput problem in manufacturing. Throughput issues may arise because the energy necessary to ablate a thick and/or highly reflective metal at a high rate requires a laser energy that is above the damage threshold of an underlying emitter (e.g., greater than 1J/cm²). Due to the necessity to have the metal completely isolated and the variation in metal thickness and laser energy, over-etching is often implemented for metal patterning. In particular, there appears to be no single laser-energy window at high-throughput/low cost available to completely remove metal and not expose the emitter to a damaging laser beam.

More specifically, in some embodiments, dielectric laser stop material layers with inorganic (or other) binders are described. For example, a screen printable paste may be suitable for use as a dielectric laser stop layer (or damage buffer layer). In one embodiment, the paste incorporates opacifying pigments, organic vehicles, as well as an inorganic binder material to improve laser ablation resistance and material adhesion. In an embodiment, reference to a paste can additionally or instead be used to refer to an ink, a colloidal material, or a gel.

To provide further context, a primary issue facing next generation solar cells is the laser damage to photovoltaic cell performance that may occur when using a laser to pattern metal structures on-cell. When a laser is used to fully electrically isolate metal structures, the metal must be fully cut, and some of the laser energy may reach the underlying structures, causing damage. One or more embodiments described herein are designed to provide a material which serves as a damage buffer material, preventing the laser energy from damaging the critical cell components, while still allowing for full metal isolation. Previous attempts to solve such issues include use of a polymeric laser stop layer which includes opacifying pigments. However, such attempts have not been very successful due to the low laser ablation resistance of polymeric resins. Another potential solution may be the use of a high firing temperature glass frit or ceramic based binders, but the required firing temperatures of such materials exceeds 500 degrees Celsius, a temperature at which cell performance can be negatively affected. Finally, metallic laser stop layers are frequently used, particularly in the printed circuit board industry, but would be inappropriate in the solar industry due to the electrical isolation requirement.

In an embodiment, a paste is applied to a surface of a solar cell as a precursor to forming a non-conductive buffer region. In one such embodiment, the paste includes opacifying pigments, a binder, and print vehicles. After printing and drying/curing, the printed film serves to block damage to the underlying device during laser processing. In a specific embodiment, the paste is formulated using the following ingredients: (1) an opacifying pigment (e.g., BaSO₄, ZnS, ZrO₂, Al₂O₃), (2) an organic vehicle for paste formulation (e.g., ethyl cellulose, terpineol, glycol ethers), and (3) an inorganic binder with a cure temperature below approximately 450 degrees Celsius (e.g., siloxanes, silsesquioxanes, other alkoxides).

In an embodiment, the pigment is included in the paste (and retained in the cured non-conductive material region) as a light scatterer to minimize laser penetration into underlying layers and to also reduce the laser energy absorbed by the laser stop layer. The opacifying pigment can be used in order to reflect, scatter, and/or absorb the incoming laser energy, minimizing laser penetration into underlying layers. Suitable pigments may have a high temperature stability in order to minimize thermal degradation under laser incidence. A high index of refraction for the pigment may be useful for maximizing light scattering. The included pigment(s) may be absorbing or transparent at the laser wavelength. Electrically insulating pigments may be preferred due to the requirement that the ultimate film be insulating. However, mildly conducting pigments can be used at a sufficiently low loading. As described in greater detail below, possible opacifying pigments include, BaSO4, ZnS, ZrO₂, Al₂O₃, carbon black, carbon nanotubes.

In an embodiment, the binder material of the paste may be either organic or inorganic, but the high temperature stability of the binder material should be high, particularly for long pulse length lasers (nanosecond and above) where the primary ablation mechanism is thermal ablation. In an embodiment, the binder can be used to adhere to the underlying cell without cracking under thermal stress. Organic binders include polyimides and cellulosic compounds and inorganic binders include siloxanes, silsesesquioxanes, or other non-Si alkoxides. The print vehicles may include solvents, viscosity modifiers, dispersants, and other commonly used screen print paste ingredients.

In an embodiment, an appropriately formulated combination of the above described ingredients allows for patterned screen printing of the paste onto a wafer, followed by a drying/firing operation to (1) remove the organic vehicles and (2) cure the inorganic (or suitable organic) binder into a rigid inorganic (or organic) matrix which holds the pigment particles in place. In one embodiment, a resulting inorganic network has a higher ablation resistance than polymeric binders, but also has a lower firing temperature than glass frit binders, which have been used in higher temperature screen printing applications. It is to be appreciated that high temperatures may not be desirable due to their negative effects on cell performance.

Alternative approaches to the embodiments described herein could include the use of glass frit binders. However, most low temperature firing glass frit binders contain toxic compounds such as lead and cadmium. Lead free, cadmium free glasses may be used, but the high firing temperatures which are required could lead to subsequent cell performance degradation. Embodiments described herein allow for a completely dry process for deposition and patterning of metal fingers for contacting solar cells. Advantages can include reduced operational expenses otherwise associated with electroplating and/or wet etch patterning of deposited metals. The result can allow for laser processing where damage to underlying layers would otherwise be highly undesirable and where insulation of metal structures is necessary.

In another aspect of embodiments of the present disclosure, a "sticky" damage buffer layer is included in a solar cell. To provide context, adhesion of a conductive foil to a solar cell can be a crucial problem during process operations that may mechanically or thermally shift the position of the foil. As an example, if the foil is not well adhered to the cell during laser welding, the foil can shift and cause misalignment of the laser with the foil. Another example process is laser patterning: if the welds are insufficiently strong or insufficiently dense, the heat of patterning may cause the foil to shift during processing, leading to poor alignment of the laser pattern with the foil. Furthermore, without the use of an adhesive, the foil may be "free" to move in areas between the foil-seed (M1-M2) contacts areas, potentially causing reliability issues. In other embodiments, an adhesive is applied separately, or the density of M1-M2 welds are increased. Thermo-compression bonding could also be used to address the adhesion solution, but neither thermo-compression nor high density welding leads to adhesion of M2 to regions where there is no M1. In an embodiment, since the damage buffer layer lies between the M1 fingers, the foil could be adhered both to the M1 finger areas (through TC or welding) as well as to the intermediate areas (e.g., through a "sticky" damage buffer).

In an embodiment, a sticky damage buffer is deposited prior to laser welding or a thermo-compression operation. The buffer may be deposited via screen printing. In a particular embodiment, the adhesive buffer layer exhibits strong adhesive properties with both the conductive foil and with the underlying silicon emitter regions. For example, in an embodiment involving aluminum foil, a paste which includes both a silicon alkoxide (such as polyphenylsilsesquioxane) and an aluminum alkoxide is used to form strong bonds to both the silicon and the aluminum foil. The adhesive or "sticky" buffer material may also include a laser reflective and/or absorbent material components in order to prevent laser damage to the underlying silicon. After deposition of the buffer precursor paste and partial cure, the foil can be "fit-up" or located with the wafer using a squeegee method. The paired combination may then be cured in order to fix the adhesive. Subsequently, the foil cell can be subjected to M1-M2 contact formation (e.g., through thermo-compression or laser welding) to be followed by laser foil patterning. An alternative may involve the use of a bi-layer damage buffer, e.g., a buffer layer fabricated by printing a damage buffer material and then printing an adhesive thereon. However, such an alternative approach may otherwise increase processing time.

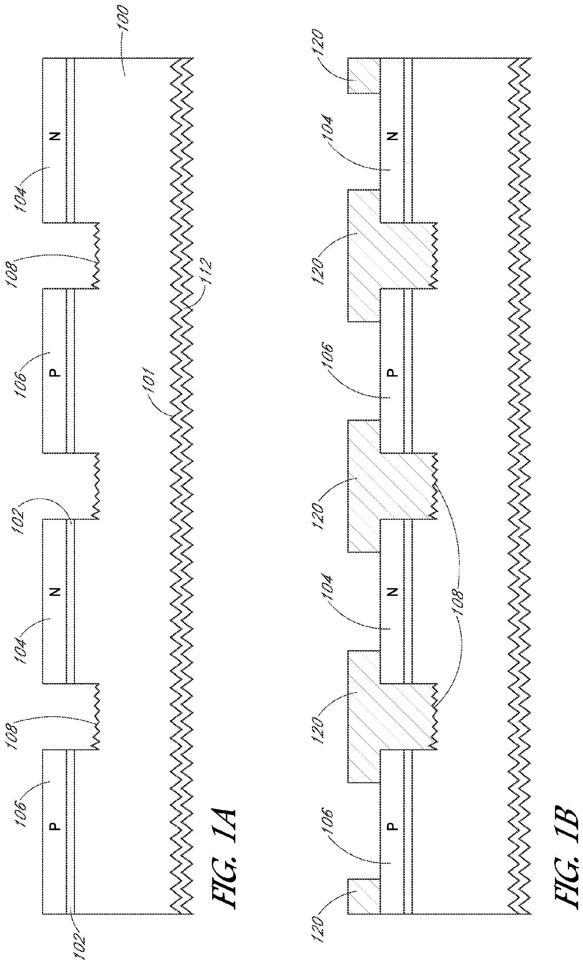

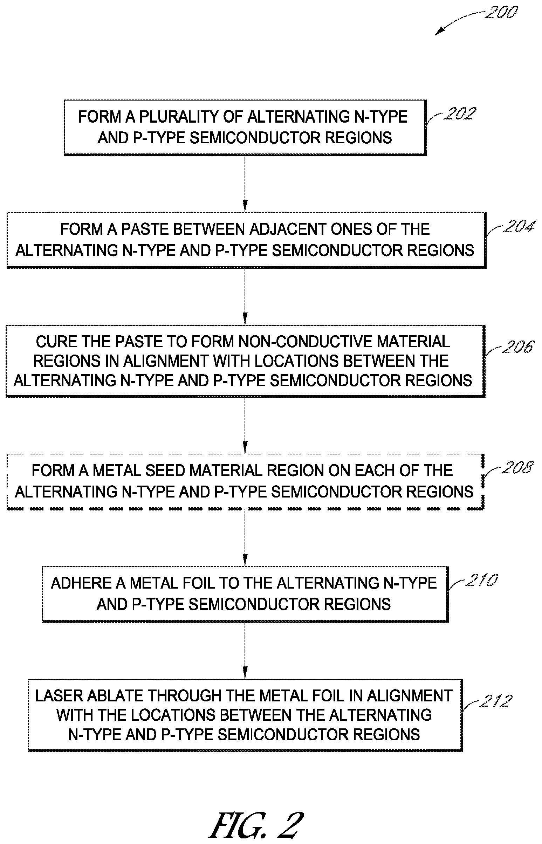

In an illustrative example of processing that may benefit from the above described pastes and resulting non-conductive material regions, a laser grooving approach provides a new electrode patterning method for interdigitated back contact solar cells based on the laser patterning of an aluminum (Al) foil (e.g., which has been laser welded or bonded by some other manner to the cell) to form an inter-digitated pattern of contact fingers. Embodiments of such an approach can be implemented to provide a damage-free method to patterning an Al foil on the wafer, avoiding complex alignment and/or masking processes. As an example, Figures 1A-1F illustrate cross-sectional views of various stages in the fabrication of a solar cell using foil-based metallization, in accordance with an embodiment of the present disclosure. Figure 2 is a flowchart listing operations in a method of fabricating a solar cell as corresponding to Figures 1A-1F, in accordance with an embodiment of the present disclosure.

Figure 1A illustrates a stage in solar cell fabrication following formation of emitter regions formed above a portion of a back surface of a substrate of a solar cell. Referring to Figure 1A and corresponding operation 202 of flowchart 200, a plurality of alternating N-type and P-type semiconductor regions are formed above a substrate. In particular, a substrate 100 has disposed there above N-type semiconductor regions 104 and P-type semiconductor regions 106 disposed on a thin dielectric material 102 as an intervening material between the N-type semiconductor regions 104 or P-type semiconductor regions 106, respectively, and the substrate 100. The substrate 100 has a light-receiving surface 101 opposite a back surface above which the N-type semiconductor regions 104 and P-type semiconductor regions 106 are formed.

In an embodiment, the substrate 100 is a monocrystalline silicon substrate, such as a bulk single crystalline N-type doped silicon substrate. It is to be appreciated, however, that substrate 100 may be a layer, such as a multi-crystalline silicon layer, disposed on a global solar cell substrate. In an embodiment, the thin dielectric layer 102 is a tunneling silicon oxide layer having a thickness of approximately 2 nanometers or less. In one such embodiment, the term "tunneling dielectric layer" refers to a very thin dielectric layer, through which electrical conduction can be achieved. The conduction may be due to quantum tunneling and/or the presence of small regions of direct physical connection through thin spots in the dielectric layer. In one embodiment, the tunneling dielectric layer is or includes a thin silicon oxide layer. In other embodiments, N-type and P-type emitter regions are formed in the substrate itself, in which case distinct semiconductor regions (such as regions 104 and 106) and the dielectric layer 102 would not be included.

In an embodiment, the alternating N-type and P-type semiconductor regions 104 and 106, respectively, are formed polycrystalline silicon formed by, e.g., using a plasma-enhanced chemical vapor deposition (PECVD) process. In one such embodiment, the N-type polycrystalline silicon emitter regions 104 are doped with an N-type impurity, such as phosphorus. The P-type polycrystalline silicon emitter regions 106 are doped with a P-type impurity, such as boron. As is depicted in Figure 1A, the alternating N-type and P-type semiconductor regions 104 and 106 may have trenches 108 formed there between, the trenches 108 extending partially into the substrate 100. Additionally, although not depicted, in one embodiment, a bottom anti-reflective coating (BARC) material or other protective layer (such as a layer amorphous silicon) is formed on the alternating N-type and P-type semiconductor regions 104 and 106.

In an embodiment, the light receiving surface 101 is a texturized light-receiving surface, as is depicted in Figure 1A. In one embodiment, a hydroxide-based wet etchant is employed to texturize the light receiving surface 101 of the substrate 100 and, possibly, the trench 108 surfaces as is also depicted in Figure 1A. It is to be appreciated that the timing of the texturizing of the light receiving surface may vary. For example, the texturizing may be performed before or after the formation of the thin dielectric layer 102. In an embodiment, a texturized surface may be one which has a regular or an irregular shaped surface for scattering incoming light, decreasing the amount of light reflected off of the light receiving surface 101 of the solar cell. Referring again to Figure 1A, additional embodiments can include formation of a passivation and/or anti-reflective coating (ARC) layers (shown collectively as layer 112) on the light-receiving surface 101. It is to be appreciated that the timing of the formation of passivation and/or ARC layers may also vary.

Figure 1B illustrates a stage in solar cell fabrication following formation of a paste between adjacent ones of the alternating N-type and P-type semiconductor regions. Referring to Figure 1B and corresponding operation 204 of flowchart 200, regions of a paste material 120 are formed between adjacent ones of the alternating N-type and P-type semiconductor regions 104 and 106. In embodiments where trenches 108 have been formed, the paste 120 is formed within the trenches 108, as is depicted in Figure 1B.

In an embodiment, the regions of the paste material 120 are formed by screen printing the paste. In one such embodiment, the screen printing permits forming the regions of the paste material 120 in a pattern that leaves exposed surfaces of the alternating N-type and P-type semiconductor regions 104 and 106, as is depicted in Figure 1B.

In an embodiment, the regions of the paste material 120 are formed from a paste suitable for forming a non-conductive region of a solar cell. In one such embodiment, the paste includes a binder, an opacifying pigment, and an organic medium mixed with the binder and the opacifying pigment. In a specific embodiment, the opacifying pigment makes up greater than approximately 25% of a total weight composition of the paste, while the organic medium makes up less than approximately 50% of the total weight composition of the paste.

In an embodiment, with reference again to the paste 120, the opacifying pigment is one such as, barium sulfate (BaSO₄), zinc sulfide (ZnS), zirconium oxide (ZrO₂), aluminum oxide (Al₂O₃), carbon black, or carbon nanotubes. The above opacifying pigments may be viewed as generally directed to white and black pigments. It is to be appreciated, however, that pigments targeted to specific wavelengths of light may be used in place of the above listed pigments or in addition to the above listed pigments. As an example, chromium oxide may be used as an opacifying pigment for green light, such as green laser light.

In an embodiment, with reference again to the paste 120, the binder is an inorganic binder such as, but not limited to, a siloxane, a silsesquioxane, or a non-silicon alkoxide. In one such embodiment, the inorganic binder is dissolved in the organic medium. It is to be appreciated that reference to the binder could be the binder itself or a precursor to a final binder material achieved upon curing of the paste. In another embodiment, the binder is an organic binder such as, but not limited to, a polyimide or a cellulose. In an embodiment, use of the term, "cellulose," throughout can refer to cellulose or a cellulose derivative or a cellulose derived compound. In an embodiment, the binder makes up greater than approximately 20% of the total weight composition of the paste. However, in other embodiment, the paste formulation may include as little 5% of the binder.

In an embodiment, with reference again to the paste 120, the organic medium is one such as, but not limited to, ethyl cellulose, terpineol, a glycol ether, or 2-butoxyethyl acetate. It is to be appreciated that, in addition to an opacifying pigment, a binder, and an organic medium, the paste 120 may also include one or more additives such as dispersants, viscosity modifiers, thinners, adhesion promoters, wetting agents, defoamers, etc.

In an embodiment, with reference again to the paste 120, the paste has a cure temperature of or less than approximately 450 degrees Celsius. In one such embodiment, substantially all of the organic medium is removable at the cure temperature but substantially none of the binder and the opacifying pigment is removable at the cure temperature. In an embodiment, the paste is free from glass frit material. In other embodiments, however, glass frit material is included. In an embodiment, the paste further includes an adhesive.

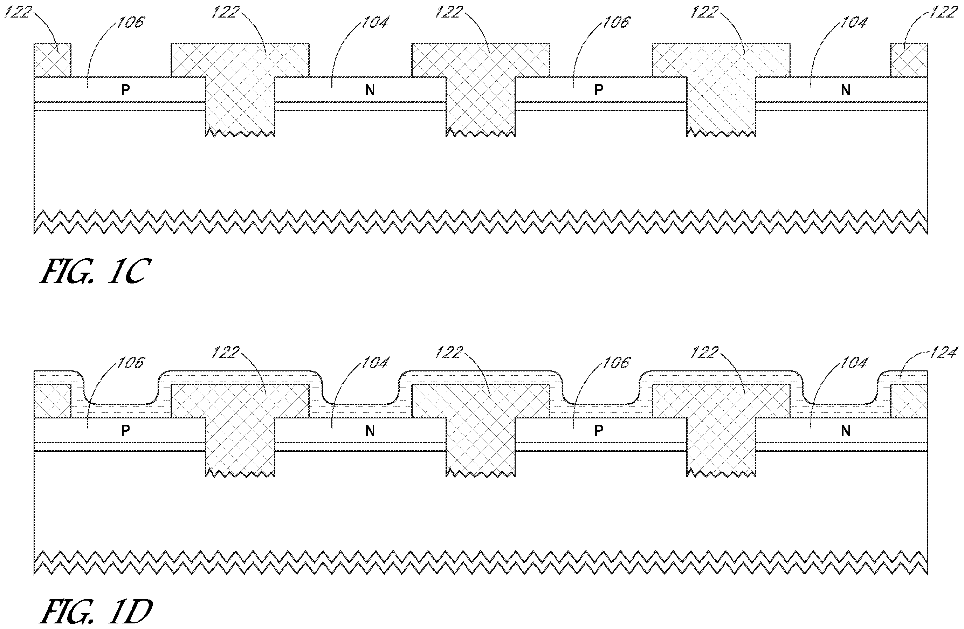

Figure 1C illustrates a stage in solar cell fabrication following curing of the paste. Referring to Figure 1C and corresponding operation 206 of flowchart 200, the regions of paste material 120 are cured to form non-conductive material regions 122 in alignment with locations between the alternating N-type and P-type semiconductor regions.

In an embodiment, curing the paste 120 to form the non-conductive material regions 122 involves heating the paste but limited to a temperature of or less than approximately 450 degrees Celsius. Such low temperature firing may leave little to no damage of the solar cell. In other embodiments, however, the paste is cured by firing to a temperature of up to 800-900 degrees Celsius, e.g., for cell architectures that may experience only minimal damage during such firing. In another embodiment, curing the paste 120 to form the non-conductive material regions 122 involves exposing to ultra-violet (UV) radiation, or a combination of heating and exposing to UV radiation. In an embodiment, upon curing, substantially all of the organic medium of the paste is removed, while substantially all of the binder and the opacifying pigment of the paste are retained. In one such embodiment, the binder of the paste is an inorganic binder, and the curing involves converting the inorganic binder to a rigid inorganic matrix of the non-conductive material regions 122.

Figure 1D illustrates a stage in solar cell fabrication following formation of a metal layer on the structure of Figure 1C. Referring to Figure 1D and corresponding optional operation 208 of flowchart 200, a metal layer (which may be referred to as a metal seed layer, or M1 layer, for the solar cell) is formed and depicted as layer 124. In an embodiment, the metal layer 124 can be viewed as providing a plurality of metal seed material regions, with a metal seed material region on each of the alternating N-type and P-type semiconductor regions 104 and 106. That is, even though a single, uninterrupted layer may be formed on both the non-conductive material regions 122 and the alternating N-type and P-type semiconductor regions 104 and 106, regions where the metal layer 124 contact the alternating N-type and P-type semiconductor regions 104 and 106 may be viewed as a corresponding metal seed regions. In alternative embodiments, a patterned metal layer is formed to provide corresponding metal seed regions. In either case, in an embodiment, the metal layer 124 is an aluminum layer. In a particular such embodiment, the aluminum layer is formed by physical vapor deposition to a thickness less than approximately 1 micron. In other embodiments, the metal layer 124 includes a metal such as, but not limited to, nickel, silver, cobalt or tungsten.

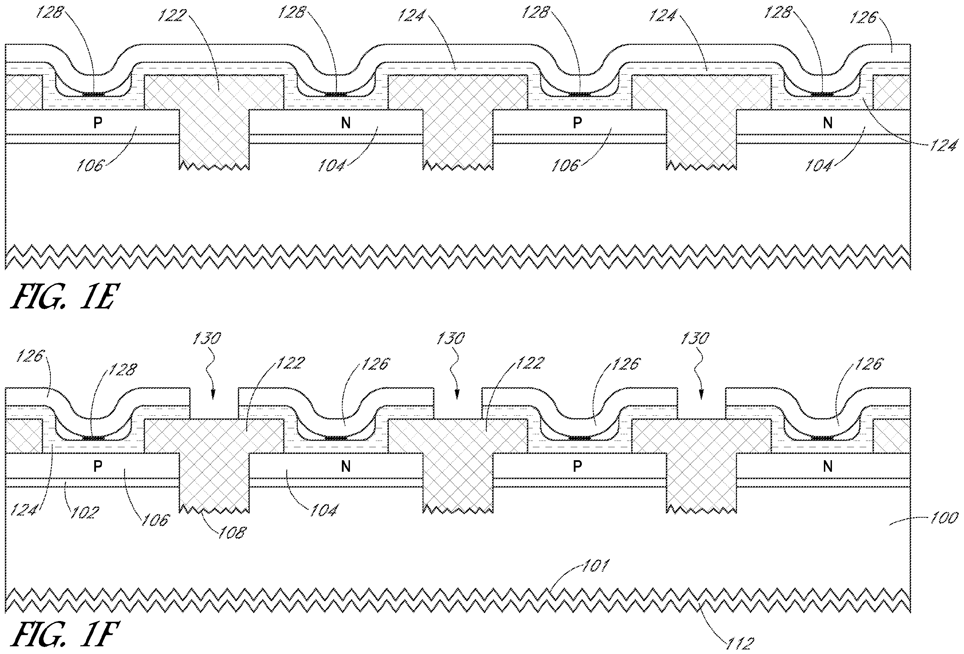

Figure 1E illustrates a stage in solar cell fabrication following positioning (or locating or fitting up) and adhesion of a metal foil on the structure of Figure 1D. Referring to Figure 1E and corresponding operation 210 of flowchart 200, a metal foil 126 is adhered to the alternating N-type and P-type semiconductor regions 104 and 106. In the embodiment shown, the metal foil 126 is placed on the metal layer 124 and welded or otherwise joined to the metal layer 124 at weld regions 128. In one such embodiment, the weld regions 128 are formed at locations above the alternating N-type and P-type semiconductor regions 104 and 106, as is depicted in Figure 1D.

In an embodiment, as depicted in Figure 1D, a metal seed material region (e.g., as metal layer 124) is provided on each of the alternating N-type and P-type semiconductor regions 104 and 106. In that embodiment, the metal foil 126 is adhered to the alternating N-type and P-type semiconductor regions 104 and 106 by adhering the metal foil 126 the plurality of metal seed material regions 124. In a specific such embodiment, a technique such as, but not limited to, a laser welding process, a thermal compression process or an ultrasonic bonding process is used.

In an embodiment, metal foil 126 is an aluminum (Al) foil having a thickness approximately in the range of 5-100 microns and, preferably, a thickness of less than approximately in the range of 50 microns. In one embodiment, the Al foil is an aluminum alloy foil including aluminum and second element such as, but not limited to, copper, manganese, silicon, magnesium, zinc, tin, lithium, or combinations thereof. In one embodiment, the Al foil is a temper grade foil such as, but not limited to, F-grade (as fabricated), O-grade (full soft), H-grade (strain hardened) or T-grade (heat treated).

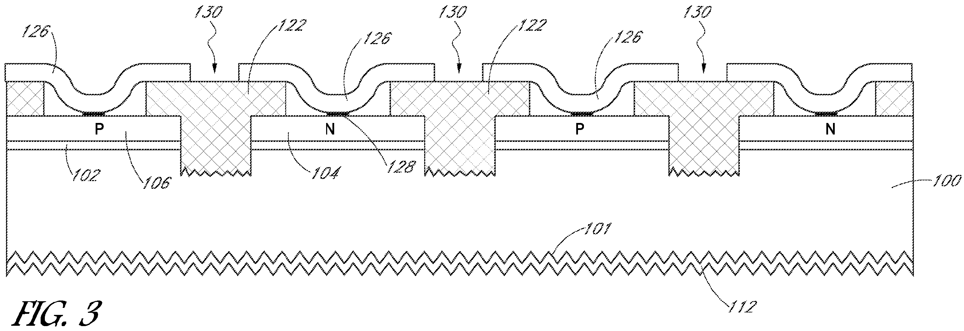

It is to be appreciated that, in accordance with another embodiment, a seedless (124 metal layer-free) approach may be implemented. In such an approach, the metal foil 126 is adhered directly to the material of the alternating N-type and P-type semiconductor regions 104 and 106, as is described in greater detail below in association with Figure 3. For example, in one embodiment, the metal foil 126 is adhered directly to alternating N-type and P-type polycrystalline silicon regions.

In other embodiment, in place of a metal foil, approaches described herein may be suitable for other blanket bulk metallization processing (e.g, blanket metal paste, blanket plating, etc.). Fabrication approaches based on blanket or patterned metal seed or blanket sputtered metal may also benefit from the pastes described herein. Furthermore, it is to be appreciated that embodiments describing a metal foil may be referring to a M1 or a M2 layer. As such, approaches described herein may involve a blanket deposited metal, in seed form, or bulk form, such as a blanket metal paste, plated metal, evaporated, sputtered, etc.

Figure 1F illustrates a stage in solar cell fabrication following patterning of the metal foil of the structure of Figure 1E. Referring to Figure 1F and corresponding operation 212 of flowchart 200, a laser ablating process 130 is performed through the metal foil 126 in alignment with the locations between the alternating N-type and P-type semiconductor regions 104 and 106 to isolate regions of remaining metal foil 126 in alignment with the alternating N-type and P-type semiconductor regions 104 and 106. The non-conductive material regions 122 act as a laser stop during the laser ablating 130.

In an embodiment, the laser ablating 130 through the metal foil 126 involves using a laser having a wavelength. The paste 120 and the resulting non-conductive material regions 122 include an opacifying pigment for scattering or absorbing light of the wavelength of the laser. In an embodiment, the laser ablation 130 is performed mask-free; however, in other embodiments, a mask layer is formed on a portion of the metal foil 126 prior to laser ablating, and is removed subsequent to laser ablating.

As described above, in another embodiment, a metal layer 124 (that is, a metal seed) is not formed. As an example, Figure 3 illustrates a cross-sectional views of another solar cell having foil-based metallization, in accordance with another embodiment of the present disclosure. Referring to Figure 3, the metal foil 126 is adhered (e.g., by welds 128) directly to the alternating N-type and P-type semiconductor regions 104 and 106. In that embodiment, the metal foil comes in direct contact with the non-conductive material regions 122. In an embodiment, the paste 120 and the resulting non-conductive material regions 122 include an adhesive. In one such embodiment, the metal foil 126 is adhered directly to the exposed portions of the alternating N-type and P-type semiconductor regions 104 and 106 and directly to the non-conductive material regions 122 by using a squeegee to fit up the metal foil 126 with the exposed portions of the alternating N-type and P-type semiconductor regions 104 and 106 and the non-conductive material regions 122.

Embodiments described herein include fabrication of a solar cell according to one or more of the above described approaches. Referring to Figures 1F and 3, in an embodiment, a solar cell includes a substrate 100. A plurality of alternating N-type 104 and P-type 106 semiconductor regions is disposed in (not shown) or above (as shown) the substrate 100. A plurality of non-conductive material regions 122 is in alignment with locations between the alternating N-type and P-type semiconductor regions 104 and 106. In one embodiment, the plurality of non-conductive material regions 122 includes a binder and an opacifying pigment, where the opacifying pigment amounts to greater than approximately 50% of the total weight composition of the plurality of non-conductive material regions. A plurality of conductive contact structures is electrically connected to the plurality of alternating N-type and P-type semiconductor regions 104 and 106. Each conductive contact structure includes a metal foil portion 126 disposed above and in alignment with a corresponding one of the alternating N-type and P-type semiconductor regions 104 and 106. In a specific embodiment, referring particularly to Figure 1F, each conductive contact structure further includes a metal seed layer 124 disposed directly between the corresponding one of the alternating N-type and P-type semiconductor regions 104 and 106 and the metal foil portion 126.

In an embodiment, the opacifying pigment of the non-conductive material regions 122 is one such as, barium sulfate (BaSO₄), zinc sulfide (ZnS), zirconium oxide (ZrO₂), aluminum oxide (Al₂O₃), carbon black, or carbon nanotubes. In an embodiment, the binder of the non-conductive material regions 122 is an inorganic binder such as, but not limited to, a siloxane, a silsesquioxane, or a non-silicon alkoxide. In another embodiment, the binder of the non-conductive material regions 122 is an organic binder such as, but not limited to, a polyimide or a cellulose.

In an embodiment, the plurality of non-conductive material regions 122 increase a solar energy absorbance efficiency of the solar cell. In one such embodiment, improved back side reflection of IR type wavelength light is achieved. That is, typical losses from IR transmission, in particular as seen for black-backsheet applications with textured trenches, may be recovered by using a paste on the rear side designed to reflect the longer wavelengths into the cell.

Referring to Figure 3 in particular, in an embodiment, the plurality of non-conductive material regions 122 further includes an adhesive. For each conductive contact, the metal foil portion 126 is disposed directly on the corresponding one of the alternating N-type and P-type semiconductor regions 104 or 106 and directly on a portion of one of the plurality of non-conductive material regions 122. In one such embodiment, the plurality of non-conductive material regions 122 includes a silicon alkoxide or an aluminum alkoxide, or both.

Although certain materials are described specifically with reference to above described embodiments, some materials may be readily substituted with others with other such embodiments remaining within the spirit and scope of embodiments of the present disclosure. For example, in an embodiment, a different material substrate, such as a group III-V material substrate, can be used instead of a silicon substrate. Additionally, although reference is made significantly to back contact solar cell arrangements, it is to be appreciated that approaches described herein may have application to front contact solar cells as well. In other embodiments, the above described approaches can be applicable to manufacturing of other than solar cells. For example, manufacturing of light emitting diode (LEDs) may benefit from approaches described herein.

Thus, approaches for foil-based metallization of solar cells and the resulting solar cells have been disclosed.

Although specific embodiments have been described above, these embodiments are not intended to limit the scope of the present disclosure, even where only a single embodiment is described with respect to a particular feature. Examples of features provided in the disclosure are intended to be illustrative rather than restrictive unless stated otherwise. The above description is intended to cover such alternatives, modifications, and equivalents as would be apparent to a person skilled in the art having the benefit of this disclosure.

In an embodiment, method of fabricating a solar cell includes forming a plurality of alternating N-type and P-type semiconductor regions in or above a substrate, forming a paste between adjacent ones of the alternating N-type and P-type semiconductor regions, curing the paste to form non-conductive material regions in alignment with locations between the alternating N-type and P-type semiconductor regions, adhering a metal foil to the alternating N-type and P-type semiconductor regions, and laser ablating through the metal foil in alignment with the locations between the alternating N-type and P-type semiconductor regions to isolate regions of remaining metal foil in alignment with the alternating N-type and P-type semiconductor regions, wherein the non-conductive material regions act as a laser stop during the laser ablating.

In one embodiment, forming the paste between adjacent ones of the alternating N-type and P-type semiconductor regions comprises screen printing the paste.

In one embodiment, curing the paste to form the non-conductive material regions comprises heating the paste to a temperature of or less than approximately 450 degrees Celsius, or exposing to ultra-violet (UV) radiation, or both.

In one embodiment, curing the paste to form the non-conductive material regions comprises removing substantially all of an organic medium of the paste and retaining substantially all of a binder and an opacifying pigment of the paste.

In one embodiment, the binder is an inorganic binder, and wherein curing the paste to form the non-conductive material regions comprises converting the inorganic binder to a rigid inorganic matrix of the non-conductive material regions.

In one embodiment, laser ablating through the metal foil comprises using a laser having a wavelength, and wherein the paste and the resulting non-conductive material regions comprise an opacifying pigment for scattering or absorbing light of the wavelength.

In one embodiment, the method further includes, prior to adhering the metal foil, forming a plurality of metal seed material regions to provide a metal seed material region on each of the alternating N-type and P-type semiconductor regions, wherein adhering the metal foil to the alternating N-type and P-type semiconductor regions comprises adhering the metal foil the plurality of metal seed material regions.

In one embodiment, adhering the metal foil to the plurality of metal seed material regions comprises using a technique selected from the group consisting of a laser welding process, a thermal compression process and an ultrasonic bonding process.

In one embodiment, adhering the metal foil to the alternating N-type and P-type semiconductor regions comprises adhering the metal foil directly to the exposed portions of the alternating N-type and P-type semiconductor regions and directly to the non-conductive material regions.

In one embodiment, the paste and the resulting non-conductive material regions comprise an adhesive, and wherein adhering the metal foil directly to the exposed portions of the alternating N-type and P-type semiconductor regions and directly to the non-conductive material regions comprises using a squeegee to fit up the metal foil with the exposed portions of the alternating N-type and P-type semiconductor regions and the non-conductive material regions.

In an embodiment, a solar cell includes a substrate, a plurality of alternating N-type and P-type semiconductor regions disposed in or above the substrate, a plurality of non-conductive material regions in alignment with locations between the alternating N-type and P-type semiconductor regions, the plurality of non-conductive material regions comprising a binder and an opacifying pigment, wherein the opacifying pigment amounts to greater than approximately 50% of the total weight composition of the plurality of non-conductive material regions and a plurality of conductive contact structures electrically connected to the plurality of alternating N-type and P-type semiconductor regions, each conductive contact structure comprising a metal foil portion disposed above and in alignment with a corresponding one of the alternating N-type and P-type semiconductor regions.

In one embodiment, the opacifying pigment is selected from the group consisting of barium sulfate (BaSO₄), zinc sulfide (ZnS), zirconium oxide (ZrO₂), aluminum oxide (Al₂O₃), carbon black, and carbon nanotubes.

In one embodiment, the binder is an inorganic binder selected from the group consisting of a siloxane, a silsesquioxane, and a non-silicon alkoxide.

In one embodiment, the binder is an organic binder selected from the group consisting of a polyimide and a cellulose.

In one embodiment, each conductive contact structure further comprises a metal seed layer disposed directly between the corresponding one of the alternating N-type and P-type semiconductor regions and the metal foil portion.

In one embodiment, the plurality of non-conductive material regions further comprise an adhesive, and wherein, for each conductive contact, the metal foil portion is disposed directly on the corresponding one of the alternating N-type and P-type semiconductor regions and directly on a portion of one of the plurality of non-conductive material regions.

In one embodiment, the plurality of non-conductive material regions comprises a silicon alkoxide or an aluminum alkoxide, or both.

In one embodiment, the plurality of non-conductive material regions increase a solar energy absorbance efficiency of the solar cell.

In an embodiment, a paste for forming a non-conductive region of a solar cell includes a binder, an opacifying pigment, and an organic medium mixed with the binder and the opacifying pigment, wherein greater than approximately 25% of a total weight composition of the paste is the opacifying pigment, and wherein less than approximately 50% of the total weight composition of the paste is the organic medium.

In one embodiment, the opacifying pigment is selected from the group consisting of barium sulfate (BaSO₄), zinc sulfide (ZnS), zirconium oxide (ZrO₂), aluminum oxide (Al₂O₃), carbon black, and carbon nanotubes.

In one embodiment, the binder is an inorganic binder selected from the group consisting of a siloxane, a silsesquioxane, and a non-silicon alkoxide.

In one embodiment, the inorganic binder is dissolved in the organic medium.

In one embodiment, the binder is an organic binder selected from the group consisting of a polyimide and a cellulose.

In one embodiment, greater than approximately 20% of the total weight composition of the paste is the binder.

In one embodiment, the organic medium is selected from the group consisting of ethyl cellulose, terpineol, a glycol ether, and 2-butoxyethyl acetate.

In one embodiment, the paste has a cure temperature of or less than approximately 450 degrees Celsius, and wherein substantially all of the organic medium is removable at the cure temperature but substantially none of the binder and the opacifying pigment is removable at the cure temperature.

In one embodiment, the paste is free from glass frit material.

In one embodiment, the paste further includes an adhesive.

## Claims

1. A solar cell, comprising:
a substrate (100);
a plurality of alternating N-type and P-type semiconductor regions (104, 106) disposed in or above the substrate (100);
a plurality of non-conductive material regions (122) in alignment with locations between the alternating N-type and P-type semiconductor regions (104, 106), the plurality of non-conductive material regions (122) comprising a binder and an opacifying pigment, wherein the opacifying pigment amounts to greater than approximately 50% of the total weight composition of the plurality of non-conductive material regions; and
a plurality of conductive contact structures electrically connected to the plurality of alternating N-type and P-type semiconductor regions (104, 106), each conductive contact structure comprising a metal foil portion (126) disposed above and in alignment with a corresponding one of the alternating N-type and P-type semiconductor regions (104, 106), wherein the opacifying pigment is selected from the group consisting of barium sulfate (BaSO₄), zinc sulfide (ZnS), zirconium oxide (ZrO₂), aluminum oxide (Al₂O₃), carbon black, and carbon nanotubes.

2. The solar cell of claim 1, wherein the binder is an inorganic binder selected from the group consisting of a siloxane, a silsesquioxane, and a non-silicon alkoxide.

3. The solar cell of claim 1, wherein the binder is an organic binder selected from the group consisting of a polyimide and a cellulose.

4. The solar cell of any one of claims 1 to 3, wherein each conductive contact structure further comprises a metal seed layer (124) disposed directly between the corresponding one of the alternating N-type and P-type semiconductor regions (104, 106) and the metal foil portion (126).

5. The solar cell of any one of claims 1 to 4, wherein the plurality of non-conductive material regions (122) further comprise an adhesive, and wherein, for each conductive contact, the metal foil portion (126) is disposed directly on the corresponding one of the alternating N-type and P-type semiconductor regions (104, 106) and directly on a portion of one of the plurality of non-conductive material regions (122).

6. The solar cell of claim 5, wherein the plurality of non-conductive material regions (122) comprises a silicon alkoxide or an aluminum alkoxide, or both.

## Patentansprüche

1. Solarzelle, umfassend:
ein Substrat (100);
eine Vielzahl sich abwechselnder n- und p-Halbleiterregionen (104, 106), die in oder über dem Substrat (100) angeordnet sind;
eine Vielzahl nichtleitender Materialregionen (122) in Ausrichtung auf Stellen zwischen den sich abwechselnden n- und p-Halbleiterregionen (104, 106), wobei die Vielzahl nichtleitender Materialregionen (122) ein Bindemittel und ein Trübungspigment umfasst, wobei das Trübungspigment mehr als ca. 50 % der Gesamtgewichtszusammensetzung der Vielzahl nichtleitender Materialregionen ausmacht; und
eine Vielzahl leitender Kontaktstrukturen, die elektrisch mit der Vielzahl sich abwechselnder n- und p-Halbleiterregionen (104, 106) verbunden sind, wobei jede leitfähige Kontaktstruktur einen Metallfolienabschnitt (126) umfasst, der über und in Ausrichtung auf eine entsprechende der sich abwechselnden n- und p-Halbleiterregionen (104, 106) angeordnet ist, wobei das Trübungspigment ausgewählt ist aus der Gruppe, bestehend aus Bariumsulfat (BaSO₄), Zinksulfid (ZnS), Zirkoniumoxid (ZrO₂), Aluminiumoxid (Al₂O₃), Ruß und Kohlenstoffnanoröhren.

2. Solarzelle nach Anspruch 1, wobei das Bindemittel ein anorganisches Bindemittel ist, das ausgewählt ist aus der Gruppe, bestehend aus einem Siloxan, einem Silsesquioxan und einem Nicht-Siliziumalkoxid.

3. Solarzelle nach Anspruch 1, wobei das Bindemittel ein organisches Bindemittel ist, das ausgewählt ist aus der Gruppe, bestehend aus einem Polyimid und einer Cellulose.

4. Solarzelle nach einem der Ansprüche 1 bis 3, wobei jede leitende Kontaktstruktur ferner eine Metallkeimschicht (124) umfasst, die direkt zwischen der entsprechenden einen der sich abwechselnden n- und p-Halbleiterregionen (104, 106) und dem Metallfolienabschnitt (126) angeordnet ist.

5. Solarzelle nach einem der Ansprüche 1 bis 4, wobei die Vielzahl nichtleitender Materialregionen (122) ferner einen Klebstoff umfasst, und wobei der Metallfolienabschnitt (126) bei jedem leitenden Kontakt direkt auf der entsprechenden einen der sich abwechselnden n- und p-Halbleiterregionen (104, 106) und direkt auf einem Abschnitt einer der Vielzahl nichtleitender Materialregionen (122) angeordnet ist.

6. Solarzelle nach Anspruch 5, wobei die Vielzahl nichtleitender Materialregionen (122) ein Siliziumalkoxid oder ein Aluminiumalkoxid oder beides umfasst.

## Revendications

1. Cellule solaire, comprenant :
un substrat (100) ;
une pluralité de régions semi-conductrices de type N et de type P alternées (104, 106), disposées dans le substrat (100) ou au dessus de ce dernier ;
une pluralité de régions de matériau non conducteur (122) alignées avec des emplacements situés entre les régions semi-conductrices de type N et de type P alternées (104, 106), la pluralité de régions de matériau non conducteur (122) comprenant un liant et un pigment opacifiant, le pigment opacifiant équivalent à plus d'environ 50 % du poids total de la composition de la pluralité des régions de matériau non conducteur ; et
une pluralité de structures de contact conductrices électriquement reliées à la pluralité de régions semi-conductrices de type N et de type P alternées (104, 106), chaque structure de contact conductrice comprenant une partie feuille métallique (126) disposée au-dessus d'une région correspondante parmi les régions semi-conductrices de type N et de type P alternées (104, 106) et en alignement avec cette dernière, le pigment opacifiant étant choisi dans le groupe constitué de sulfate de baryum (BaSO₄), de sulfure de zinc (ZnS), d'oxyde de zirconium (ZrO₂), d'oxyde d'aluminium (Al₂O₃), de noir de carbone et de nanotubes de carbone.

2. Cellule solaire selon la revendication 1, le liant étant un liant inorganique choisi dans le groupe constitué d'un siloxane, d'un silsesquioxane et d'un alcoolate ne contenant pas de silicium.

3. Cellule solaire selon la revendication 1, le liant étant un liant organique choisi dans le groupe constitué d'un polyimide et d'une cellulose.

4. Cellule solaire selon l'une quelconque des revendications 1 à 3, chaque structure de contact conductrice comprenant en outre une couche de germe métallique (124) disposée directement entre la région correspondante parmi les régions semi-conductrices de type N et de type P alternées (104, 106) et la partie feuille métallique (126).

5. Cellule solaire selon l'une quelconque des revendications 1 à 4, la pluralité de régions de matériau non conducteur (122) comprenant en outre un adhésif, et, pour chaque contact conducteur, la partie feuille métallique (126) étant disposée directement sur la région correspondante parmi les régions semi-conductrices de type N et de type P alternées (104, 106) et directement sur une partie d'une région de matériau non conducteur parmi la pluralité des régions de matériau non conducteur (122).

6. Cellule solaire selon la revendication 5, la pluralité de régions de matériau non conducteur (122) comprenant un alcoolate de silicium et un alcoolate d'aluminium, ou les deux.
